Europäisches Patentamt

European Patent Office

Office européen des brevets

(19)

(11) Publication number : **0 465 069 A1**

(12) # EUROPEAN PATENT APPLICATION

(21) Application number : 91305665.1

(22) Date of filing : 21.06.91

(51) Int. Cl.$^5$ : **H01L 21/00, C23G 5/00**

(30) Priority : 29.06.90 US 546466

(43) Date of publication of application :
08.01.92 Bulletin 92/02

(84) Designated Contracting States :
**DE ES GB IT**

(71) Applicant : **AMERICAN TELEPHONE AND TELEGRAPH COMPANY**
**550 Madison Avenue**
**New York, NY 10022 (US)**

(72) Inventor : **Olasupo, Kolawole R.**
**439 East Walnut Street**
**Kutztown, Pennsylvania 19530 (US)**

(74) Representative : **Johnston, Kenneth Graham et al**
**AT&T (UK) LTD. AT&T Intellectual Property Division 5 Mornington Road**
**Woodford Green Essex, IG8 OTU (GB)**

(54) **Method for eliminating Na contamination in semiconductor manufacturing.**

(57)    Alkali metal ion contamination in semiconductor integrated circuit processing is reduced by washing at least some of the interior surfaces of plasma etching machines with a solution comprising water.

EP 0 465 069 A1

## Technical Field

This invention relates to a method of semiconductor integrated circuit manufacturing that includes a step which reduces sodium(Na) contamination in the integrated circuit.

## Background of the Invention

As the number of individual devices within an integrated circuit increases and the sizes of the individual devices decrease, the presence of unwanted substances within the integrated circuit often becomes an even more severe problem than it was previously. For example, the presence of particles on the surface of a wafer may decrease the accuracy of the pattern transfer process from, e.g., the mask to the wafer surface, even to the point of rendering individual devices within the circuit inoperative.

Unwanted substances may adversely alter device characteristics, even if they do not always render the device inoperative. For example, trapped charges in the gate oxide may lead to unwanted shifts in the threshold voltage of an individual field effect transistor. Such shifts are undesirable. It is now well established that alkali metal, typically Na, ions are the dominant cause of such threshold voltage shifts.

Elimination of Na ion contamination in the semiconductor manufacturing process is thus an area of great concern to those skilled in the art. It is not an easy area to address because of the almost inevitable presence of Na ions in many of the process steps. For example, the resists which are present during the pattern transfer process from mask to wafer almost inevitably contain Na ions. During the etching step of the pattern transfer process, the Na ions may move into a dielectric layer and create problems for subsequent processing steps and even for device operation. There may be additional sources of Na ion contamination.

## Summary of the Invention

A method of semiconductor integrated circuit manufacturing which comprises depositing a dielectric layer on a patterned substrate and etching said dielectric layer on said substrate in a plasma etching machine comprising interior surfaces at least some of which have been cleaned with a method comprising washing in a solution comprising a Na ion solvent. In a preferred embodiment, the dielectric layer comprises silicon dioxide. In a further preferred embodiment, the Na ion solvent comprises deionized water.

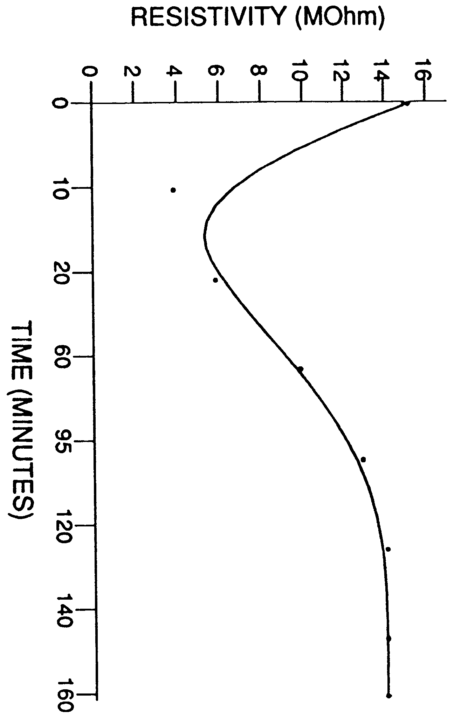

## Brief Description of the Drawing

The FIGURE plots time horizontally versus the resistivity of the solution vertically.

## Detailed Description

Alkali metal, especially sodium(Na), ion contamination is a significant problem in many aspects of semiconductor integrated circuit manufacturing. The contamination can come from many sources including, for example, the resists used in transferring patterns to a resist coated substrate, as well as other sources. The transferring step comprises exposing selected portions of a resist coated substrate to radiation. Those skilled in the art will readily select a suitable resist and coat the substrate with the resist. Selected portions of the resist coated substrate are exposed to radiation which reacts with the resist and creates differential etch characteristics between the exposed and unexposed portions of the resist. Those skilled in the art will readily select appropriate sources of radiation. The substrate may be exposed directly to the pattern, as by electron beam exposure, or it may be exposed through a mask. After exposure, the pattern is transferred to the substrate by etching. This is frequently done in a plasma etching machine. Such machines are well known to those skilled in the art and need no further description.

A dielectric layer is deposited by conventional techniques such as plasma-assisted deposition. An exemplary dielectric comprises silicon oxide. The dielectric generally does not have a planar surface because it is deposited on a non-planar surface; i.e., the patterned substrate does not have a planar surface. A plasma etch removes some of the dielectric material but also smoothes the dielectric surface.

I have found that the alkali metal contamination present after the etching process has been completed can be significantly reduced by cleaning at least some of the interior surfaces of the etching machine with a solution that comprises a Na solvent. Those skilled in the art will readily select such a solvent. An exemplary solvent is reverse osmosis deionized water. The reverse osmosis reduces particulate contamination. I have found that brief treatment in an acid, e.g., a $HNO_3$, HCl, and $C_2H_5OOH$ mixture, both followed by a brief rinse in deionized water improves the results obtained in the reverse osmosis deionized water. The term, deionized water, is well known to those skilled in the art and needs no further explanation.

The water is deionized because the use of deionized water decreases the possibility that the cleaning process will introduce unwanted contaminants. The etching machine parts are immersed after the acid mixture treatment in the deionized reverse osmosis water which is desirably circulating. The resistivity of the water is monitored. Initially it decreases abruptly as the Na ions enter the water, it then increases slowly as the ions are removed and the water circulates. An exemplary plot of the resistivity versus time is shown in the FIGURE which plots time horizontally in units of minutes versus the resistivity vertically in units of Mohm-cm. As can be seen, the resistivity decreases initially and then slowly increases and returns to approximately its initial value.

The etching machine is then reassembled and the wafers etched using well known etching techniques. Typically, a single washing, before initial operation, will suffice to reduce the Na ion contamination.

Na ion contamination is measured using conventional and well known techniques, such as triangular voltage sweep, secondary ion mass spectrometry, or a capacitance-voltage plot. The Na ion concentration was $5.1 \times 10^9/cm^2$ before etching. After etching in machines with and without cleaning parts as described, the concentrations were $2 \times 10^{10}/cm^2$ and $5 \times 10^{12}/cm^2$, respectively.

Variations will be readily though of by those skilled in the art. For example, multichamber etching machines can be used.

**Claims**

1. A method of semiconductor integrated circuit manufacturing which comprises depositing a dielectric layer on a patterned substrate and etching said dielectric layer in a plasma etching machine CHARACTERISED BY interior surfaces at least some of which have been cleaned by a method comprising washing in a solution comprising a Na ion solvent.

2. A method as recited in claim 1 in which said solution comprises deionized water and said method further comprises monitoring the resistivity of the solution.

3. A method as recited in claim 2 further comprising washing said surfaces in an acid and water mixture before washing in said deionized water.

4. A method as recited in claim 3 in which said acid and water mixture comprises $HNO_3$ $HCl$ and $C_2H_5OOH$.

5. A method as recited in claim 1 in which said dielectric layer comprisessilicon oxide.

6. A method of semiconductor integrated circuit manufacturing which comprises depositing a dielectric layer on a patterned substrate and etching said dielectric layer in a plasma etching machine comprising interior surfaces at least some of which have been cleaned by a method comprising washing in a solution comprising a Na ion solvent, said solution comprises deionized water and said method further comprises monitoring the resistivity of the solution and washing said surfaces in an acid and water mixture which comprises $HNO_3$ HC1, and $C_2H_5OOH$.

RESISTIVITY (MOhm)

TIME (MINUTES)

EP 0 465 069 A1

**European Patent Office**

# EUROPEAN SEARCH REPORT

Application Number

EP 91 30 5665

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-4 832 753 (CHERRY)<br>* column 1, line 6 - line 33; claim 1 * | 1,6 | H01L21/00<br>C23G5/00 |
| A | US-A-4 786 352 (BENZING)<br>* abstract * | 1 | |
| A | US-A-4 841 645 (BETTCHER)<br>* column 5, line 1 - column 6, line 15 * | 1 | |
| | | | **TECHNICAL FIELDS SEARCHED (Int. Cl.5)**<br><br>H01L<br>C23G |

The present search report has been drawn up for all claims

| Place of search | Date of completion of the search | Examiner |
|---|---|---|
| THE HAGUE | 14 OCTOBER 1991 | RIEUTORT A.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)